# EUROPÄISCHE PATENTSCHRIFT

(11) **EP 3 847 704 B1**
(45) Veröffentlichungstag und Bekanntmachung des Hinweises auf die Patenterteilung: **01.10.2025**
(21) Anmeldenummer: 19762104.8
(22) Anmeldetag: 23.08.2019
(51) Int. Cl.: H10N 80/10, H03B 7/08

(54) **GUNNDIODE UND VERFAHREN ZUM ERZEUGEN EINER TERAHERTZSTRAHLUNG**
GUNN DIODE AND METHOD FOR GENERATING A TERAHERTZ RADIATION
DIODE GUNN ET PROCÉDÉ DESTINÉ À ÉMETTRE UN RAYONNEMENT TÉRAHERTZIEN

(30) Priorität: 05.09.2018 DE 102018121672
(43) Veröffentlichungstag der Anmeldung: 14.07.2021
(73) Patentinhaber: Technische Universität Darmstadt, 64289 Darmstadt (DE)
(72) Erfinder: YILMAZOGLU, Oktay, 64846 Groß-Zimmern (DE); HAJO, Ahid S., 64287 Darmstadt (DE)
(74) Vertreter: LifeTech IP Spies & Behrndt Patentanwälte PartG mbB
(86) Internationale Anmeldenummer: PCT/EP2019/072556
(87) Internationale Veröffentlichungsnummer: WO 2020/048792

(56) Entgegenhaltungen:
- WO-A1-2008/095639
- US-A- 3 440 425
- US-A- 3 573 469
- BELYAEV A E ET AL: "Depth profiling of strain and carrier concentration by cleaved surface scanning of GaN Gunn-diode: confocal Raman microscopy", SEMICONDUCTOR SCIENCE AND TECHNOLOGY, IOP PUBLISHING LTD, GB, vol. 28, no. 10, 16 August 2013 (2013-08-16), pages 105011, XP020251191, ISSN: 0268-1242, [retrieved on 20130816], DOI: 10.1088/0268-1242/28/10/105011

## Beschreibung

Ausführungsbeispiele der vorliegenden Erfindung beziehen sich auf eine Gunndiode, einen Schalter zur Erzeugung einer Terahertzstrahlung (THz-Strahlung) und ein Verfahren zum Erzeugen einer THz-Strahlung und insbesondere auf eine GaN-Gunndiode mit Laserbestrahlung und Feldplattentechnologie.

### HINTERGRUND

Der Gunn-Effekt wurde erfolgreich in GaAs- oder InP-basierten Halbleiterbauelemente genutzt, um Hochfrequenzsignale zu erzeugen. Diese Halbleitermaterialien weisen Materialeigenschaften wie Energiebandverläufe, Ladungsträgergeschwindigkeiten und -beweglichkeiten auf, die den Elektronentransfer des Gunn-Effektes in Gang zu setzen.

Gunndioden nutzen diesen Effekt, indem durch geeignete Beschaltung (z.B. durch Anlegen einer entsprechenden Versorgungsspannung) bewirkt wird, dass Elektronen sich aufstauen und in Schüben (wie Wellen) durch die Diode wandern. Dies wiederum resultiert in einer Erzeugung und anschließenden Abstrahlung elektromagnetischer Wellen entsprechend dieser Frequenz. Bekannte Gunndiode sind offenbart in A.E. Belyaev et al. Semicond.Sci. Technol. 28 (2013) 105011 oder in US 3,573,469 oder in US 3,440,425 oder in WO 2008/095639 A1. Insbesondere für sehr hohe Frequenzen (z.B. im Terahertzbereich) haben bekannten GaAs-basierte Halbleiterbauelemente eine Reihe von Nachteilen. Diese sind darin begründet, dass Sättigungsgeschwindigkeit für Elektronen sowie Elektronentransferzeiten für diese hohen Frequenzen zu gering sind. Somit sind diese Halbleiterbauelement für Frequenzen im Terahertzbereich kaum einsetzbar. Weiterhin ist die elektrische Schwellfeldstärke für den sog. "Elektronentransfereffekt" bzw. die Energiebandlücke zu gering für hohe Ausgangsleistungen.

Da andererseits ein wachsender Bedarf nach THz-Strahlungsquellen besteht, ist es wünschenswert Alternativen zu den GaAs-basierten Halbleiterbauelemente zu finden.

### KURZBESCHREIBUNG DER ERFINDUNG

Zumindest ein Teil der obengenannten Probleme wird durch eine Gunndiode nach Anspruch 1, durch einen Schalter nach Anspruch 8 und ein Verfahren nach Anspruch 12 gelöst. Die abhängigen Ansprüche definieren weitere vorteilhafte Ausführungsformen für die Gegenstände der unabhängigen Ansprüche. Die vorliegende Erfindung bezieht sich auf eine Gunndiode mit einer ersten Kontaktschicht, einer zweiten Kontaktschicht, einer aktiven Schicht, einem Substrat und einem optischen Eingang. Die aktive Schicht basiert auf einem Galliumnitrid (GaN)-basierte Halbleitermaterial (z.B. Alₓ In_{y} Ga_{(1-x-y)} N) und ist zwischen der ersten Kontaktschicht und der zweiten Kontaktschicht ausgebildet. Die aktive Schicht mit der ersten Kontaktschicht und der zweiten Kontaktschicht sind auf dem Substrat ausgebildet. Der optische Eingang ist ausgebildet, um ein Laserlicht zu empfangen, um einen Ladungsträgertransport zwischen Energiebändern der aktiven Schicht durch eine Laserbestrahlung zu erleichtern oder auszulösen.

Die GaN-basierten Halbleitermaterialien, die für die aktive Schicht genutzt werden, können insbesondere Folgendes umfassen: einen binären Verbindungshalbleiter (d.h. GaN), einen ternären Verbindungshalbleiter (z.B. AlGaN, InGaN) oder einen quartären Verbindungshalbleiter (z.B. AlInGaN) oder weitere Verbindungshalbleiter mit noch mehr Komponenten, aber GaN als ein Bestandteil. Optional umfasst das Substrat eines der folgenden Materialien: Galliumnitrid, Silizium, Siliziumcarbid.

Optional umfasst die Gunndiode weiter einen Anodenkontakt (Anodenelektrode) und einen Kathodenkontakt (Kathodenelektrode). Die erste Kontaktschicht und/oder die zweite Kontaktschicht kann/können im Vergleich zur aktiven Schicht höher dotierte Bereiche desselben Basismaterial sein. Der Anodenkontakt kann optional an einer Rückseite des Substrates ausgebildet sein, sodass er über das Substrat mit der ersten Kontaktschicht (elektrisch) verbunden ist. Der Kathodenkontakt kann die zweite Kontaktschicht elektrisch kontaktieren. Beispielsweise umfasst die erste Kontaktschicht und die zweite Kontaktschicht eine Dotierung in einem Bereich von 1 × 10¹⁸ cm⁻³ bis 5 × 10¹⁸ cm⁻³ und der Anodenkontakt eine Dotierung von mindestens 10²⁰cm⁻³. Die aktive Schicht kann auch eine Dotierung aufweisen, um die gewünschte Bandstruktur zu erzeugen. Optional kann die erste Kontaktschicht durch das Substrat gebildet sein. Ohne dass die Erfindung darauf eingeschränkt werden soll, kann die Dotierung beispielsweise mit Silizium erfolgen (es sind aber noch viele andere Materialien möglich).

Optional umfasst die Gunndiode weiter einen Kühlkörper (aktiv oder passiv), der eine höhere Wärmeleitfähigkeit als die des Substrates aufweist, um eine Wärmesenke zu bilden. Eine thermische Verbindung der aktiven Schicht mit dem Kühlkörper kann über das Substrat hergestellt werden.

Optional umfasst die Gunndiode weiter eine Feldplatte, die insbesondere ein Metall aufweist, wobei die aktive Schicht zwischen der Feldpatte und dem Substrat ausgebildet ist, ohne seitlich über die Feldplatte hinauszuragen. Die Feldplatte bewirkt eine Homogenisierung des Feldes im aktiven Bereich der Gunndiode. Insbesondere werden dadurch Feldüberhöhungen an Ecken und Kanten vermieden (z.B. am Rand der Gunndiode). Die Feldplatte kann beispielsweise Chrom oder Gold oder ein anderes Material oder mehrere Schichten davon aufweisen.

Die Gunndiode umfasst weiter eine Passivierungsschicht, die derart angeordnet ist, dass die aktive Schicht mit der ersten Kontaktschicht und der zweiten Kontaktschicht zwischen der Passivierungsschicht und dem Substrat ausgebildet sind.

Der optische Eingang ist durch ein für den Laser transparentes Material gebildet. Es ist zumindest eine der folgenden Komponenten mit einem für den Laser transparenten Material gebildet:
- der ersten Kontaktschicht,
- der zweiten Kontaktschicht,
- der Passivierungsschicht.

Diese Schichten oder Teile davon können auch als Wellenleiter ausgebildet sein, um die Laserstrahlung dem aktiven Bereich zuzuführen.

Ausführungsbeispiele beziehen sich auch auf einen Schalter zur Erzeugung einer Terahertzstrahlung mit einer Gunndiode wie sie zuvor beschrieben wurde. Der Schalter kann auch den Laser aufweisen (z.B. als integralen Bestandteil), wobei der Laser mit dem optischen Eingang koppelt und ausgebildet ist, um eine kontinuierliche Laserstrahlung oder eine gepulste Laserstrahlung zu erzeugen. Hierdurch kann auch eine kontinuierliche oder gepulste THz-Strahlung erzeugt werden. Ebenso kann eine Steuereinheit zur Ansteuerung des Lasers und/oder der Gunndiode vorgesehen sein.

Der Laser kann beispielsweise eine Infrarot-Licht oder ein ultraviolettes Licht erzeugen. Der Laser kann aber auch im sichtbaren Spektralbereich operieren. Optional ist der Laser gepulst und weist eine Laseranstiegszeit im Nanosekundenbereich oder Picosekundenbereich oder Femtosekundenbereich auf, um so die gewünschte THz-Strahlung zu triggern.

Ausführungsbeispiele beziehen sich auch auf eine Terahertz-Strahlungsquelle mit einem zuvor beschriebenen Schalter und einer (integrierten) Antenne.

Ausführungsbeispiele beziehen sich auch auf ein Verfahren zum Erzeugen einer Terahertzstrahlung. Das Verfahren umfasst:
- Anlegen einer Versorgungsspannung an einer Gunndiode wie sie zuvor beschrieben wurde; und
- Bestrahlen der Gunndiode mit einer Laserstrahlung, um einen Ladungsträgertransfer in der aktiven Schicht der Gunndiode auszulösen oder zu unterstützen.

Optional kann die Versorgungsspannung dauerhaft angelegt werden, z.B. wenn die Laserstrahlung gepulst ist. Die Versorgungsspannung kann auch eine Betriebsfrequenz aufweisen, z.B. wenn es eine kontinuierliche Laserstrahlung genutzt wird.

### KURZBESCHREIBUNG DER FIGUREN

Die Ausführungsbeispiele der vorliegenden Erfindung werden besser verstanden anhand der folgenden detaillierten Beschreibung und den beiliegenden Zeichnungen der unterschiedlichen Ausführungsbeispiele, die jedoch nicht so verstanden werden sollten, dass sie die Offenbarung auf die spezifischen Ausführungsformen einschränken, sondern lediglich der Erklärung und dem Verständnis dienen.
- Fig. 1: zeigt eine Gunndiode gemäß einem Ausführungsbeispiel der vorliegenden Erfindung.
- Fig. 2: veranschaulicht den Gunn-Effekt, der in bestimmten Halbleitermaterialien auftritt und gemäß Ausführungsbeispielen zur Erzeugung einer THz-Strahlung genutzt wird.
- Fig. 3: zeigt ein weiteres Ausführungsbeispiel der Gunndiode mit weiteren optionalen Komponenten.
- Fig. 4: zeigt noch ein Ausführungsbeispiel für die Gunndiode.
- Fig. 5: zeigt beispielhaft eine arrayweise Herstellung der Gunndioden gemäß Ausführungsbeispielen.
- Fig. 6: zeigt ein Flussdiagramm für ein Verfahren zum Erzeugen einer THz-Strahlung gemäß Ausführungsbeispielen der vorliegenden Erfindung.

### DETAILLIERTE BESCHREIBUNG

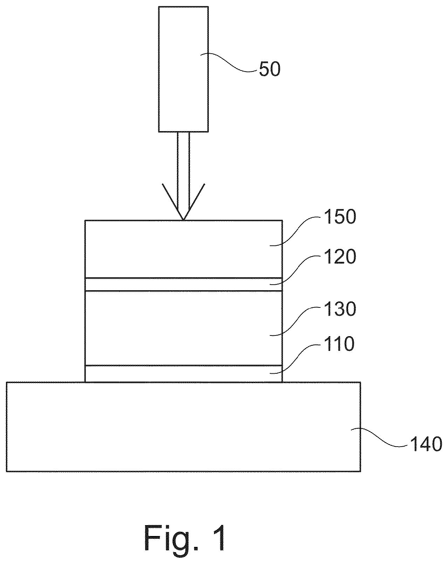

**Fig. 1** zeigt eine Gunndiode gemäß einem Ausführungsbeispiel der vorliegenden Erfindung. Die Gunndiode umfasst: eine ersten Kontaktschicht 110, eine zweite Kontaktschicht 120 und eine aktive Schicht 130 basierend auf einem Galliumnitrid (GaN)-basierte Halbleitermaterial, die zwischen der ersten Kontaktschicht 110 und der zweiten Kontaktschicht 120 ausgebildet ist. Außerdem umfasst die Gunndiode ein Substrat 140 auf dem die aktive Schicht 130 mit der ersten Kontaktschicht 110 und der zweiten Kontaktschicht 120 ausgebildet sind, und einen optischen Eingang 150 für einen Laser 50, um einen Ladungsträgertransfer zwischen Extrema (Minima für Elektronen; Maxima für Löcher) von Energiebändern der aktiven Schicht 130 durch eine Laserbestrahlung zu erleichtern oder auszulösen.

Die erste Kontaktschicht 110 oder die zweite Kontaktschicht 120 können den Anodenkontakt bilden oder damit elektrisch verbunden sein. Der Kathodenkontakt ist dann mit der jeweils anderen Kontaktschicht elektrisch verbunden oder bildet diese. Die aktive Schicht 130 und optional auch die Kontaktschichten 110, 120 können mit einer mehr oder weniger starken Dotierung gebildet werden (p-Dotierung oder n-Dotierung). Das GaN-basierte Halbeitermaterial kann weitere Elemente aufweisen, die gezielt eingebracht werden, um den unten beschriebenen Effekt weiter zu fördern.

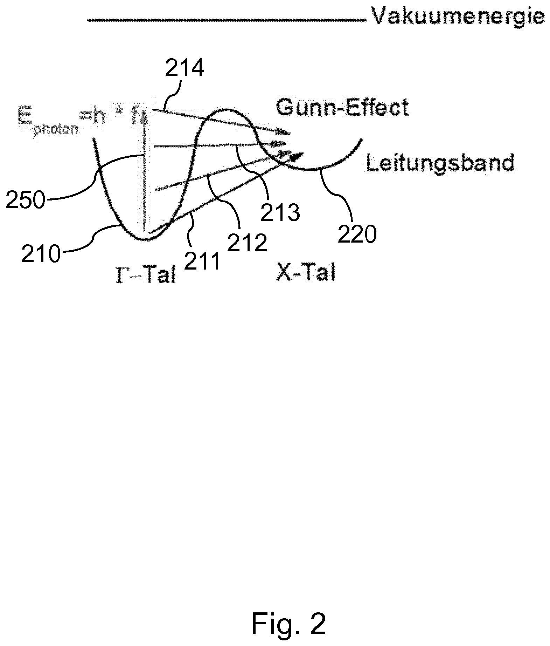

**Fig. 2** veranschaulicht den Gunn-Effekt, der in bestimmten Halbleitermaterialien auftritt und gemäß Ausführungsbeispielen zur Erzeugung einer THz-Strahlung genutzt wird. Die Energiebänder der entsprechenden Halbleitermaterialien haben relative Maxima bzw. Minima in einem geringen energetischen Abstand. Elektronen (oder auch Löcher), die zum Beispiel aus einem Valenzband in ein Leitungsband angeregt wurden, befinden sich zunächst in einem ersten Minimum 210 (z.B. ein absolutes Minimum des sogenannten *Γ*-Tals) des Leitungsbandes. Erreichen die beispielhaften Elektronen in einem elektrischen Feld eine Energie, die im Bereich der Energiedifferenz zwischen dem ersten Minimum 210 und zweiten (relativen) Minimum 220 (z.B. sogenanntes X-Tal) liegt, werden sie durch Streuung (z.B. an optischen Phononen) in das benachbarte Minimum 220 transferiert (siehe erster Übergang 211). Das elektrische Feld kann beispielsweise durch das Anlegen einer Spannung erzeugt werden. Da für diese Materialien die beispielhaften Elektronen eine hohe effektive Masse im benachbarten Minimum, dem so genannten Seitental, aufweisen (wegen der Energiebandkrümmung), haben sie dort eine kleinere Beweglichkeit. Aus diesem Grund sinkt der elektrische Strom deutlich - trotz steigender Spannung. D.h. es ergibt sich ein negativer differentieller Widerstand.

Der Übergang von dem *Γ*-Tal 210 in das X-Tal 220 wird gemäß Ausführungsbeispielen weiter dadurch erleichtert, dass die Gunndiode mittels eines Lasers bestrahlt wird. Dadurch erhalten die Ladungsträger im *Γ*-Tal 210 eine zusätzliche Energie, die proportional zur Frequenz f der Laserstrahlung ist (Eₚₕₒₜₒₙ = h*f). Diese Energieaufnahme 250 erleichtert den Übergang in das X-Tal 220. Wenn der erste Übergang 211 ein Übergang ohne eine Laseranregung darstellt, wird der zweite, dritte und vierte Übergang 212, 213, 214 durch die aufgenommene Energie 250 mit zunehmender Frequenz erleichtert.

Ausführungsbeispiele nutzen dies, um den Übergang durch die Laserstrahlung auszulösen (triggern) oder zumindest zu unterstützen, sodass der Übergang für möglichst viele Ladungsträger in einer kurzen Zeit ausgeführt wird.

Wegen dem schnellen Stromabfall sind diese Bauelemente als Schalter nutzbar. Im Gegensatz zu konventionellen GaAs-Schaltern (z.B. GaAs Photoswitch oder GaAs Photoconductor) werden gemäß Ausführungsbeispielen die beispielhaften Elektronen nicht vom Valenzband bzw. "Deep Levels" zwischen dem Valenz- und Leitungsband ins Leitungsband transferiert. Vielmehr transferiert die Laserbestrahlung die Elektronen vom *Γ*-Tal 210 (erstes Minimum) im Leitungsband zum Satellitental 220 (erneut im Leitungsband).

Der wesentliche Vorteil bei dieser Vorgehensweise besteht darin, dass der Transfer in (Sub-) Picosekunden (< 10 ps oder < 1 ps) erfolgen kann. Daher kommt es zu sehr schnellen Stromänderungen und die Bauelemente können daher zur Erzeugung von THz-Strahlung eingesetzt werden.

Die Laserbestrahlung gemäß Ausführungsbeispielen dient somit zum Triggern (Auslösen) und/oder Begünstigung der THz-Abstrahlung von GaN-Gunndioden. Es wird damit die Stabilität erhöht und die Erzeugung von breitbandigen THz-Strahlungen (50GHz- mehrere THz) ermöglicht. Hierfür kann eine kontinuierliche Laserbestrahlung und/oder eine gepulste Bestrahlung mit einem Nano-, Pico- oder Femtosekunden-Takt genutzt werden, um den Elektronentransfereffekt (Gunn-Effekt) zu bewirken/fördern. Die gepulste Bestrahlung bieten daher den Vorteil, dass ein sehr schneller Elektronentransfereffekt erreicht wird.

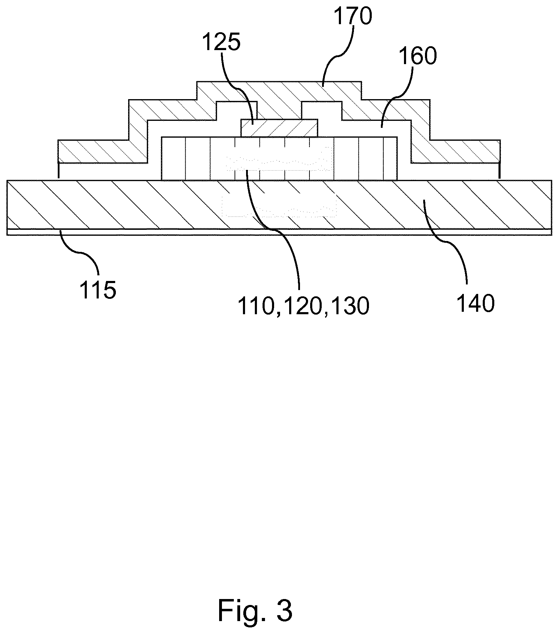

Fig. 3 zeigt ein weiteres Ausführungsbeispiel, bei dem der Schichtstapel der Gunndiode (erste Kontaktschicht 110, zweite Kontaktschicht 120, aktive Schicht 130) auf dem Substrat 140 durch eine (Kathoden-) Elektrode 125 kontaktiert wird. Die Elektrode 125 kontaktiert ihrerseits eine Feldplatte 170, die sich über dem Schichtstapel 110, 120, 130 der Gunndiode erstreckt, sodass der Schichtstapel 110, 120, 130 zwischen dem Substrat 140 und der Feldplatte 170 ausgebildet ist und dem elektrischen Feld durch die angelegte Spannung ausgesetzt ist.

Die Elektrode 125 wie auch die Feldplatte 170 weisen beispielsweise ein Metall (eine oder mehrere Schichten) auf. Die Feldplatte 170 kann zum Beispiel Chrom oder Gold aufweisen. Zwischen der Feldplatte 170 und dem Schichtstapel 110, 120, 130 ist eine Passivierungsschicht 160 ausgebildet, die eine elektrische Isolierung zwischen der Feldplatte 170 und den Schichten 110, 120, 130 der Gunndiode erreicht.

Optional ist es möglich, dass die Passivierungsschicht 160 als Lichtwellenleiter genutzt wird, um die Laserstrahlung entlang der Passivierungsschicht 160 zu dem Schichtstapel 110, 120, 130 der Gunndiode hin zu führen. Optional ist es ebenfalls möglich, dass entweder das Substrat 140 oder eine oder mehrere Kontaktschichten 110, 120 oder Teile davon transparent ausgebildet sind, um das Laserlicht entlang dieser Schichten zu leiten. Eine dieser Schichten kann somit Teil des optischen Eingangs 150 sein oder diesen darstellen.

Für die Erzeugung von THz-Strahlung ist es von besonderem Vorteil, dass Nitrid-Materialien für viel höhere Frequenzen und Leistungen geeignet sind. Mit diesen Materialien sind beispielsweise folgende Effekte erreichbar:
- eine hohe Sättigungsgeschwindigkeit für Elektronen (für GaN > 2 mal höher als in GaAs),
- viel höhere elektrische Schwellfeldstärke für den sog. "Elektronentransfereffekt" (für GaN > 50 mal höher als in GaAs),
- eine große Energiebandlücke,
- während Signalquellen auf der Basis von GaAs- und InP-Bauelementen jeweils Grenzfrequenzen von 100 GHz bzw. 200 GHz (für die Grundmode) aufweisen, liegen die berechneten Grenzwerte für GaN-Dioden beispielsweise bei über 700 GHz.

Es gibt viele Materialien, die für das Substrat 140 geeignet sind. Gunndioden auf Saphir-Substraten sind zwar möglich, führen aber zu verschiedenen Effekten und Problemen. Hierzu gehören z.B. das Auftreten der Elektromigrationseffekte sowie die hohen Serienwiderstände. Außerdem macht die geringe Wärmeleitfähigkeit von Saphir die Implementierung von Wärmesenken häufig schwierig. Dies führt zu hohen DC-Verlusten und reduziert die Zuverlässigkeit. Besser geeignet sind (z.B. wegen ihrer guten thermischen Leitfähigkeit): Substrate aus GaN, aus SiC oder aus Silizium. Insbesondere in Kombination mit der Feldplatte 170 können damit stabile negative differentielle Widerstände erreicht werden.

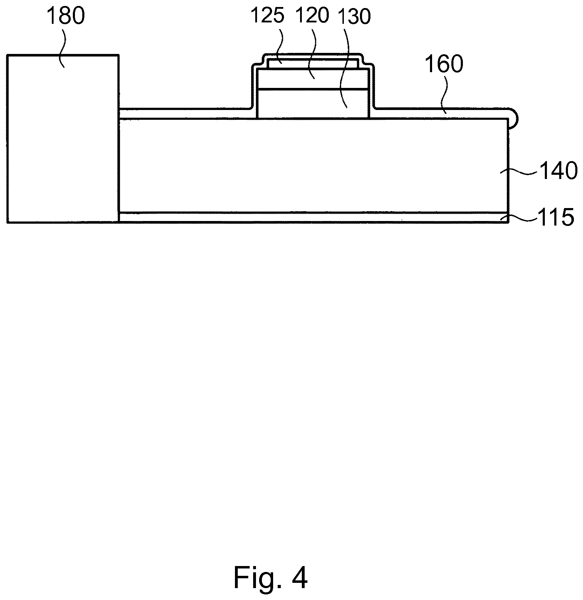

Fig. 4 zeigt ein Ausführungsbeispiel der vorliegenden Erfindung, bei dem die aktive Schicht 130 direkt auf dem Substrat 140 ausgebildet wird und das Substrat 140 selbst oder Bereiche davon als erste Kontaktschicht 110 wirken. Außerdem ist in dem Ausführungsbeispiel der Fig. 4 unterhalb des Substrates 140 (gegenüberliegend zu der aktiven Schicht 130) eine beispielhafte Anodenelektrode 115 vorgesehen. Der Strom wird durch das Substrat 140 zu der Gunndiode geführt. Ebenso ist auf der zweiten Kontaktschicht 120 eine beispielhafte Kathodenelektrode 125 ausgebildet. Über der Kathodenelektrode 125 und den überstehenden Bereichen des Substrates 140 ist, wie in der Fig. 3 auch, eine Passivierungsschicht 160 ausgebildet. In diesem Ausführungsbeispiel ist keine Feldplatte vorgesehen, kann jedoch ebenso oberhalb der Passivierungsschicht 160 ausgebildet werden.

Das Ausführungsbeispiel der Fig. 4 umfasst weiter einen optionalen Kühlkörper 180, der seitlich neben dem Substrat 140 ausgebildet und eine eine Kühlsenke darstellt. Der Kühlkörper 180 kann eine aktive Kühlung (z.B. ein Lüfter oder ein Peltierelement) oder eine passive Kühlung (z.B. Kühlrippen) bereitstellen. Der Wärmestrom erfolgt dabei über das Substrat 140 hinweg zu der Gunndiode bzw. zu der aktiven Schicht 130. Hierfür ist es besonders vorteilhaft, wenn das Substrat 140 gemäß Ausführungsbeispielen GaN, Si oder SiC aufweist (und nicht Saphir).

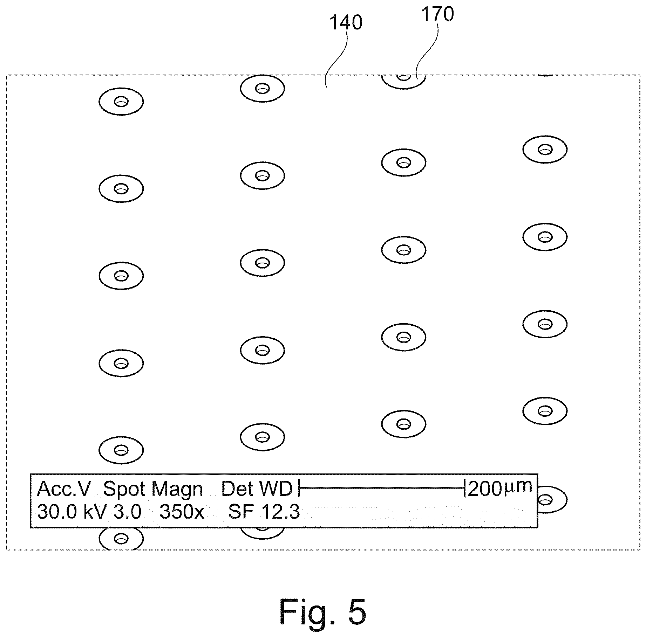

Fig. 5 zeigt beispielhaft eine Herstellung der Gunndiode aus einem Array von Gunndioden auf nur einem Substrat. Beispielhaft sind dabei viele voneinander getrennte Feldplatten 170 dargestellt, die auf dem zugrunde liegenden Substrat 140 ausgebildet sind. Die Gunndiode selbst erstrecken sich dabei jeweils als eine Erhebung von dem Substrat 140.

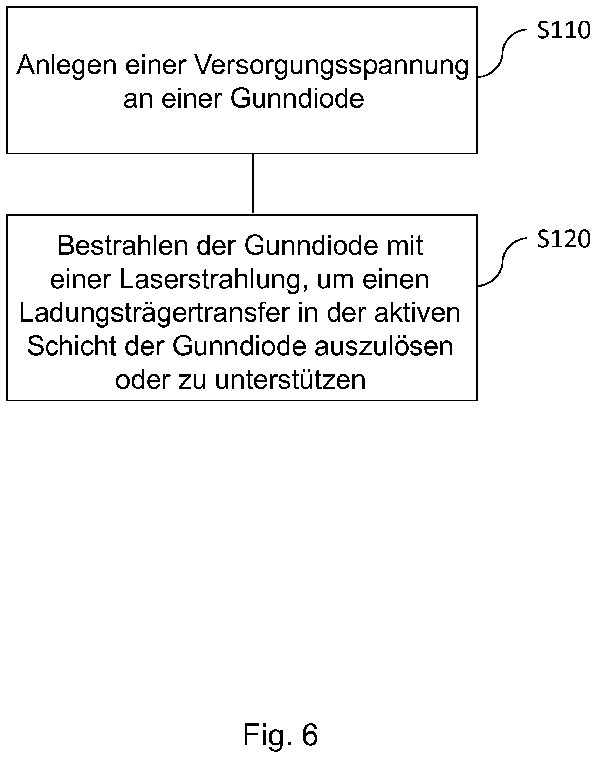

Fig. 6 zeigt ein Flussdiagramm für ein Verfahren zum Erzeugen einer Terahertzstrahlung. Das Verfahren umfasst die Schritte:
- Anlegen S110 einer Versorgungsspannung an eine Gunndiode wie sie zuvor beschrieben wurde; und
- Bestrahlen S120 der Gunndioden mit einer Laserstrahlung, um einen Ladungsträgertransfer in der aktiven Schicht 130 der Gunndiode auszulösen oder zu unterstützen.

Die Versorgungsspannung kann konstant sein oder mit einer Betriebsfrequenz getaktet sein. Gemäß Ausführungsbeispielen ist es ebenfalls möglich, dass der Gunn-Effekt durch eine gepulste Laserstrahlung ausgelöst wird, wobei in diesem Fall die Versorgungsspannung dauerhaft anliegen kann.

Die Vorteile von Ausführungsbeispielen können wie folgt zusammengefasst werden:
- Gegenüber konventionellen GaAs-Schaltern können viel größere Stromänderungen stabil und schnell geschaltet werden.
- Da die Ausgangsleistung proportional zum Quadrat der Stromänderung ist (P~Δ I²), kann eine THz-Strahlung mit hoher Leistung erzeugt werden.
- Außerdem kann eine breitbandige THz-Strahlung erzeugt werden (Bandbreiten von 50GHz bis mehrere THz), wobei eine integrierte breitbandige Antenne zur THz-Abstrahlung ausreicht.
- Mit der Feldplattentechnologie wird eine gleichmäßige Versorgung der Gunndiode möglich, weil die parasitären elektrischen Feldüberhöhungen am Diodenrand sowie die Elektromigrationseffekte minimiert werden. Eine schnelle Zerstörung der Bauelemente infolge der Elektromigrationseffekte von der Anode zur Kathode bei hohen Feldstärken können vermieden werden, sodass sich die Zuverlässigkeit erheblich erhöht. Mit der Feldplattentechnologie auf der Diode werden die benötigten hohen elektrischen Feldstärken stabiler an die Gunndiode angelegt.
- GaN-Gunndiode auf Substrate mit besserer Wärmeleitfähigkeit wie GaN, Si und SiC (höher als auf Saphir) sind problemlos herstellbar. Die hohen Verlustleistungen, die in Gunndioden üblich sind, können somit bessere abgeführt werden.
- Die Gunndioden auf den neuen Substraten (GaN, Si, SiC) zeigen eine stabile Strom-Spannungskennlinie mit einem gut ausgeprägten negativen differentiellen Widerstand. Wegen der hohen thermischen Leitfähigkeit können Wärmesenken mit einem größeren Außenkontakt besser umgesetzt werden.
- Es können viel größere Feldstärken als die Schwellenfeldstärke verwendet werden.
- Der Einsatz oder die Integration mit dem passenden Resonator sowie entsprechenden Vorspannungs- und Signalkopplungsvorrichtungen kann zur Erzeugung von Millimeterwellen bis hin zu hohen THz-Frequenzen mit hohen Leistungen führen.

Vorteile der Laserbestrahlung:
- Mit einer kontinuierlichen Laserbestrahlung (Infrarot bis Ultraviolett) können die Elektronen im Leitungsband eine höhere Energie besitzen und einfacher den Elektronentransfereffekt (Gunn-Effekt) durchführen. Somit sinkt die benötigte Betriebsspannung der Gunndiode. Die THz-Erzeugung wird erleichtert und stabilisiert sich, reduziert jedoch die Ausgangsleistung.
- Mit einer gepulsten Laserbestrahlung (Infrarot bis Ultraviolett) im Nanosekundenbereich kann die Wärmeentwicklung stark gedrosselt werden. Erneut wird die THz-Erzeugung erleichtert und stabilisiert. GaN-Gunndiode können mit einer eigens hergestellten Hochspannungsquelle mit Pulsbreiten von 40 Nanosekunden gespeist werden. Die Versorgungsspannung kann bei der gepulsten Laserbestrahlung dauerhaft anliegen.

Beide Methoden stabilisieren die ursprüngliche GaN-Gunndiode, wobei die Betriebsfrequenz mit einem externen Resonator festgelegt werden kann. Die gepulsten Laser können mit einer Laseranstiegszeit im Pico- oder Femtosekundenbereich verwendet werden. Diese ermöglichen einen sehr schnellen Elektronentransfereffekt.

Ausführungsbeispiele können somit insbesondere für THz-Schalter genutzt werden, die ähnlich zu den THz-Schaltern basierend auf GaAs-Photoschaltern oder GaAs-Photoleitern durch schnellen Stromänderungen die THz-Strahlung erzeugen.

Da Ausführungsbeispiele zur Herstellung und Verwendung von GaN-Gunndioden die Erzeugung von extrem hohen THz-Frequenzen und hohe Ausgangsleistungen (viel höher als für GaAs- und InP-Gunndioden) ermöglichen, werden vielfältige bildgebende und spektroskopische Anwendungen im THz-Frequenzbereich damit möglich.

Die in der Beschreibung, den Ansprüchen und den Figuren offenbarten Merkmale der Erfindung können sowohl einzeln als auch in beliebiger Kombination für die Verwirklichung der Erfindung wesentlich sein.

### BEZUGSZEICHENLISTE

- 50: Laser
- 110, 120: Kontaktschichten
- 115, 125: Elektrode(n) (Kathodenkontakt/Anodenkontakt)
- 130: aktive Schicht
- 140: Substrat
- 150: optischer Eingang
- 160: Passivierung
- 170: Feldplatte
- 180: Kühlkörper
- 210,220: Minima des Leitungsbandes
- 211,212, ...: Übergänge zwischen den Minima des Leitungsbandes

## Patentansprüche

1. Gunndiode mit:
einer ersten Kontaktschicht (110) und einer zweiten Kontaktschicht (120);
einer aktiven Schicht (130) basierend auf einem Galliumnitrid (GaN)-Halbleitermaterial, die zwischen der ersten Kontaktschicht (110) und der zweiten Kontaktschicht (120) ausgebildet ist;
einem Substrat (140) auf dem die aktive Schicht (130) mit der ersten Kontaktschicht (110) und der zweiten Kontaktschicht (120) ausgebildet sind; und
einem optischen Eingang (150) für einen Laser (50), um einen Ladungsträgertransfer zwischen Extrema (210, 220) der Energiebänder der aktiven Schicht (140) durch eine Laserbestrahlung zu erleichtern oder auszulösen, wobei der optische Eingang (150) durch ein für den Laser transparentes Material für zumindest einer der folgenden Komponenten gebildet ist:
- der ersten Kontaktschicht (110),
- der zweiten Kontaktschicht (120),
- eine Passivierungsschicht (160),
wobei die Passivierungsschicht (160) derart angeordnet ist, dass die aktive Schicht (130) mit der ersten Kontaktschicht (110) und der zweiten Kontaktschicht (120) zwischen der Passivierungsschicht (160) und dem Substrat (140) ausgebildet sind.

2. Gunndiode nach Anspruch 1, wobei das Substrat eines der folgenden Materialien aufweist: Galliumnitrid, Silizium, Siliziumcarbid.

3. Gunndiode nach Anspruch 1 oder Anspruch 2, die weiter einen Anodenkontakt und einen Kathodenkontakt aufweist,
wobei die erste Kontaktschicht (110) und/oder die zweite Kontaktschicht im Vergleich zur aktiven Schicht (130) höher dotierte Bereiche desselben Basismaterial sind und der Anodenkontakt über das Substrat (140) mit der ersten Kontaktschicht (110) und Kathodenkontakt mit der zweiten Kontaktschicht elektrisch verbunden ist, und
wobei die erste Kontaktschicht (110) und die zweite Kontaktschicht (120) eine Dotierung in einem Bereich von 1 × 10¹⁸ cm⁻³ bis 5 × 10¹⁸ cm⁻³ und der Anodenkontakt eine Dotierung von mindestens 10²⁰cm⁻³ aufweisen.

4. Gunndiode nach einem der vorhergehenden Ansprüche, bei der die erste Kontaktschicht (110) durch das Substrat (140) gebildet ist.

5. Gunndiode nach einem der vorherigen Ansprüche, die weiter einen Kühlkörper (180) aufweist, der eine höhere Wärmeleitfähigkeit als die des Substrates (140) aufweist.

6. Gunndiode nach Anspruch 5, bei der eine thermische Verbindung der aktiven Schicht (130) mit dem Kühlkörper (180) über das Substrat (140) hergestellt ist.

7. Gunndiode nach einem der vorherigen Ansprüche, die weiter eine Feldplatte (170), insbesondere aus einem Metall, aufweist, wobei die aktive Schicht (130) zwischen der Feldpatte (170) und dem Substrat (140) ausgebildet ist, ohne seitlich über die Feldplatte (170) hinauszuragen.

8. Schalter zur Erzeugung einer Terahertzstrahlung mit einer Gunndiode nach einem der vorherigen Ansprüche.

9. Schalter nach Anspruch 8, der weiter den Laser (50) aufweist, der mit dem optischen Eingang (150) koppelbar und ausgebildet ist, um eine kontinuierliche Laserstrahlung oder eine gepulste Laserstrahlung zu erzeugen.

10. Schalter nach Anspruch 9, wobei der gepulste Laser (50) eine Laseranstiegszeit im Nanosekundenbereich oder Picosekundenbereich oder Femtosekundenbereich aufweist.

11. Terahertz-Strahlungsquelle mit einem Schalter nach einem der Ansprüche 8 bis 10 und einer integrierten Antenne.

12. Verfahren zum Erzeugen einer Terahertzstrahlung mit:
Anlegen (S110) einer Versorgungsspannung an einer Gunndiode nach einem der Ansprüche 1 bis 7; und
Bestrahlen (S120) der Gunndiode mit einer Laserstrahlung, um einen Ladungsträgertransfer in der aktiven Schicht (130) der Gunndiode auszulösen oder zu unterstützen.

13. Verfahren nach Anspruch 12, wobei
die Versorgungsspannung dauerhaft angelegt wird, wenn die Laserstrahlung gepulst ist, oder
mit einer Betriebsfrequenz angelegt wird, wenn es eine kontinuierliche Laserstrahlung ist.

## Claims

1. A Gunn diode comprising:
a first contact layer (110) and a second contact layer (120);
an active layer (130), based on a gallium nitride (GaN) semiconductor material, which is formed between the first contact layer (110) and the second contact layer (120);
a substrate (140) on which the active layer (130) is formed together with the first contact layer (110) and the second contact layer (120); and
an optical input (150) for a laser (50) in order to facilitate or trigger a charge carrier transfer between extrema (210, 220) of the energy bands of the active layer (140) by means of laser irradiation, wherein the optical input (150) is formed by a material that is transparent to the laser for at least one of the following components:
- the first contact layer (110),
- the second contact layer (120),
- a passivation layer (160),
wherein the passivation layer (160) is arranged such that the active layer (130) is formed, together with the first contact layer (110) and the second contact layer (120), between the passivation layer (160) and the substrate (140).

2. The Gunn diode according to claim 1, wherein the substrate comprises one of the following materials: gallium nitride, silicon, silicon carbide.

3. The Gunn diode according to claim 1 or claim 2, further comprising an anode contact and a cathode contact,
wherein the first contact layer (110) and/or the second contact layer are, compared to the active layer (130), more highly doped regions of the same base material, and the anode contact is electrically connected to the first contact layer (110) via the substrate (140) and the cathode contact is electrically connected to the second contact layer, and
wherein the first contact layer (110) and the second contact layer (120) have a doping in a range of 1 x 10¹⁸ cm⁻³ up to 5 x 10¹⁸ cm⁻³ and the anode contact has a doping of at least 10²⁰ cm⁻³.

4. The Gunn diode according to any of the preceding claims, in which the first contact layer (110) is formed by the substrate (140).

5. The Gunn diode according to any of the preceding claims, further comprising a heat sink (180) which has a higher thermal conductivity than that of the substrate (140).

6. The Gunn diode according to claim 5, in which a thermal connection of the active layer (130) to the heat sink (180) is established via the substrate (140).

7. The Gunn diode according to any of the preceding claims, further comprising a magnetoresistor (170), in particular made of a metal, wherein the active layer (130) is formed between the magnetoresistor (170) and the substrate (140) without projecting laterally beyond the magnetoresistor (170).

8. A switch for generating terahertz radiation, comprising a Gunn diode according to any of the preceding claims.

9. The switch according to claim 8, further comprising the laser (50) which can be coupled to the optical input (150) and is designed to generate continuous laser radiation or pulsed laser radiation.

10. The switch according to claim 9, wherein the pulsed laser (50) has a laser ramp-up time in the nanosecond range, picosecond range, or femtosecond range.

11. A terahertz radiation source comprising a switch according to any of claims 8 to 10 and an integrated antenna.

12. A method for generating terahertz radiation, comprising:
applying (S110) a supply voltage to a Gunn diode according to any of claims 1 to 7; and
irradiating (S120) the Gunn diode with laser radiation in order to trigger or support a charge carrier transfer in the active layer (130) of the Gunn diode.

13. The method according to claim 12, wherein
the supply voltage is applied permanently if the laser radiation is pulsed, or
is applied at an operating frequency if it is continuous laser radiation.

## Revendications

1. Diode Gunn comportant :
une première couche de contact (110) et une seconde couche de contact (120) ;
une couche active (130) basée sur un matériau semi-conducteur à nitrure de gallium (GaN), laquelle est réalisée entre la première couche de contact (110) et la seconde couche de contact (120) ;
un substrat (140) sur lequel la couche active (130) est réalisée avec la première couche de contact (110) et la seconde couche de contact (120) ; et
une entrée optique (150) pour un laser (50) afin de faciliter ou de déclencher un transfert de porteurs de charge entre des extrémités (210, 220) des bandes d'énergie de la couche active (140) par un rayonnement laser, dans laquelle l'entrée optique (150) est formée par un matériau transparent au laser pour au moins l'un des composants suivants :
- la première couche de contact (110),
- la seconde couche de contact (120),
- une couche de passivation (160),
dans laquelle la couche de passivation (160) est disposée de telle sorte que la couche active (130) avec la première couche de contact (110) et la seconde couche de contact (120) sont réalisées entre la couche de passivation (160) et le substrat (140).

2. Diode Gunn selon la revendication 1, dans laquelle le substrat présente l'un des matériaux suivants : nitrure de gallium, silicium, carbure de silicium.

3. Diode Gunn selon la revendication 1 ou la revendication 2, laquelle présente en outre un contact d'anode et un contact de cathode,
dans laquelle la première couche de contact (110) et/ou la seconde couche de contact sont des zones plus fortement dopées du même matériau de base par rapport à la couche active (130) et le contact d'anode est connecté électriquement à la première couche de contact (110) par l'intermédiaire du substrat (140) et le contact de cathode est connecté électriquement à la seconde couche de contact, et
dans laquelle la première couche de contact (110) et la seconde couche de contact (120) présentent un dopage compris dans une plage allant de 1 x 10¹⁸ cm⁻³ à 5 x 10¹⁸ cm⁻³ et le contact d'anode présente un dopage d'au moins 10²⁰ cm⁻³.

4. Diode Gunn selon l'une des revendications précédentes, dans laquelle la première couche de contact (110) est formée par le substrat (140).

5. Diode Gunn selon l'une des revendications précédentes, présentant en outre un dissipateur thermique (180) présentant une conductivité thermique supérieure à celle du substrat (140).

6. Diode Gunn selon la revendication 5, dans laquelle une liaison thermique de la couche active (130) avec le dissipateur thermique (180) est produite par l'intermédiaire du substrat (140).

7. Diode Gunn selon l'une des revendications précédentes, présentant en outre une magnétorésistance (170), en particulier en un métal, dans laquelle la couche active (130) est réalisée entre la magnétorésistance (170) et le substrat (140) sans faire saillie latéralement au-delà de la
magnétorésistance (170).

8. Commutateur pour la génération d'un rayonnement térahertz avec une diode Gunn selon l'une des revendications précédentes.

9. Commutateur selon la revendication 8, présentant en outre le laser (50) qui peut être couplé à l'entrée optique (150) et qui est configuré pour générer un rayonnement laser continu ou un rayonnement laser pulsé.

10. Commutateur selon la revendication 9, dans lequel le laser pulsé (50) présente un temps de montée du laser de l'ordre de la nanoseconde ou de la picoseconde ou de la femtoseconde.

11. Source de rayonnement térahertz comportant un commutateur selon l'une des revendications 8 à 10 et une antenne intégrée.

12. Procédé pour la génération d'un rayonnement térahertz comportant :
l'application (S110) d'une tension d'alimentation à une diode Gunn selon l'une des revendications 1 à 7 ; et
l'irradiation (S120) de la diode Gunn avec un rayonnement laser afin de déclencher ou d'aider à un transfert de porteurs de charge dans la couche active (130) de la diode Gunn.

13. Procédé selon la revendication 12, dans lequel
la tension d'alimentation est appliquée en permanence lorsque le rayonnement laser est pulsé, ou
est appliquée avec une fréquence de fonctionnement s'il s'agit d'un rayonnement laser continu.
